# EUROPEAN PATENT SPECIFICATION

(11) **EP 1 426 821 B1**
(45) Date of publication and mention of the grant of the patent: **18.10.2017**
(21) Application number: 03257400.6
(22) Date of filing: 24.11.2003
(51) Int. Cl.: G03F 1/24, G21K 1/06, G03F 7/00

(54) **Method of fabricating an optical element, lithographic apparatus and device manufacturing method**
Methode zur Erzeugung eines optischen Elements, lithographischer Apparat sowie Methode zur Herstellung eines Geräts
Méthode pour réaliser un élément optique, appareil lithographique ainsi que méthode pour fabriquer un objet

(30) Priority: 26.11.2002 EP 02258121
(43) Date of publication of application: 09.06.2004
(73) Proprietor: ASML Netherlands B.V., 5504 DR Veldhoven (NL)
(72) Inventor: Dierichs, Marcel, Mathijs, Theodore, Marie, 5914 WR Venlo (NL); Loopstra, Erik, Roelof, 5591 BA Heeze (NL)
(74) Representative: Slenders, Petrus J. W.

(56) References cited:
- US-A- 5 257 132
- US-B1- 6 392 792

## Description

The present invention relates to a method of fabricating an optical element which optical element is for use in a lithographic projection apparatus. The present invention so relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792. In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4. For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO98/40791. US 6,392,792 discloses a diffraction optics element for use in a lithographic projection apparatus. The diffraction element is fabricated by forming a so called etch stack comprising alternating layers of first and second materials on a substrate surface. The two materials provide relative etch selectivity meaning that a particular reactive ion etch will react with one of the materials but not with the other and vice versa. A relief profile is then made in the stack by forming a resist film on top of the stack and exposing one or more patterned regions of the resist film and developing the resist to uncover one or more regions of the stack whilst other regions of the stack are left covered. A reactive ion etch is then used to etch away the exposed part of the top layer of the stack. Because the reactive ion etch is chosen such that it only reacts with the material of the top layer, the depth of the etching can be precisely controlled because the etch can go no deeper than the depth of the top layer of material. By repeating the steps of forming a resist film on the stack, patterning that resist film and reactive ion etching, a relief profile can be built up on the substrate. The final step involves depositing a multi-layer reflection film over the relief profile such that the film has an outer contour that substantially matches of the relief profile.

One of the problems with the method disclosed in US 6,392,792 is that the edge of the etched away layers may be very sharp so that the deposited multi-layer reflection film does not always adhere well to the relief profile. Additionally etching may cause surface roughness which will cause stray light and intensity loss.

It is an object of the present invention to provide alternative forms of fabricating an optical element and in particular to provide a fabrication method for an optical element which does not suffer from the above mentioned problems.

This and other objects are achieved by a method of fabricating an optical element comprising the steps of:
(a) providing a substrate;
(b) depositing a multi-layer stack comprising alternating layers of first and second materials on a surface of said substrate wherein said two materials can provide relative etch selectivity;
(c) forming a resist layer on top of said stack;
(d) patterning said resist layer and developing said resist layer to uncover one or more regions of said stack;
(e) etching said one or more uncovered regions of said stack to remove parts of one layer of said multi-layer stack exposed by step
(d) to form a relief profile; and
(f) depositing a film on said relief profile,characterized in that the etching is isotropic plasma etching such that sides of removed parts are inclined to form an angle of more than 90° with a newly exposed layer.
This method has the advantages that plasma etching can be performed at a higher pressure than reactive ion etching and in that plasma etching is often faster. Furthermore, none of the atomic effects that are sometimes present with reactive ion etching occur. Finally, plasma etching is isotropic meaning that it will etch the layers of first and second material so that edges of etched away areas have a smoother profile than when etched away by reactive ion etching which is anisotropic meaning that it etches away more quickly in certain crystal directions than others which can lead to faceted etching and the above mentioned problems. Thus, plasma etching results in an optical element in which the film is more securely deposited on the relief profile. In this way adverse edge effects of the optical element can also be avoided.

According to a further aspect of the invention there is provided a lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate,
characterized by an optical element fabricated by the above method.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
- characterized by diffracting said projection beam using a diffraction optical element fabricated by the above method.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 A-E illustrates schematically the fabrication technique of a preferred embodiment;

In the Figures, corresponding reference symbols indicate corresponding parts.

### Embodiment 1

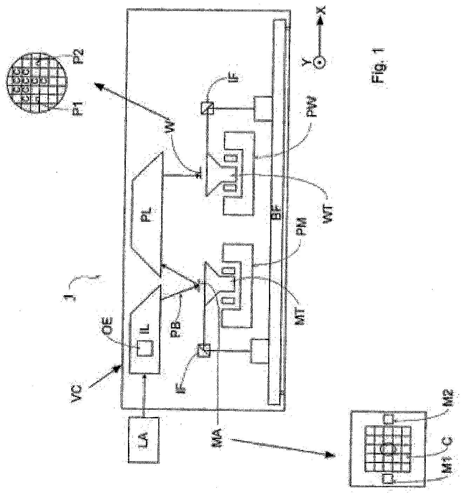

Figure 1 schematically depicts a lithographic projection apparatus according to a particular embodiment of the invention. The apparatus comprises:
a radiation system Ex, IL, for supplying a projection beam PB of radiation (e.g. EUV radiation), which in this particular case also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e.g.* mirror group) for imaging an irradiated portion of the mask MA onto a target portion C (*e.g.* comprising one or more dies) of the substrate W. As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g*. the y direction) with a speed v, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

Figure 1 also illustrates an optical element OE in the illumination system IL. The optical element OE may be a diffraction or refraction optical element and is manufactured in accordance with the present invention. The optical element may, for example, be a Fresnel lens.

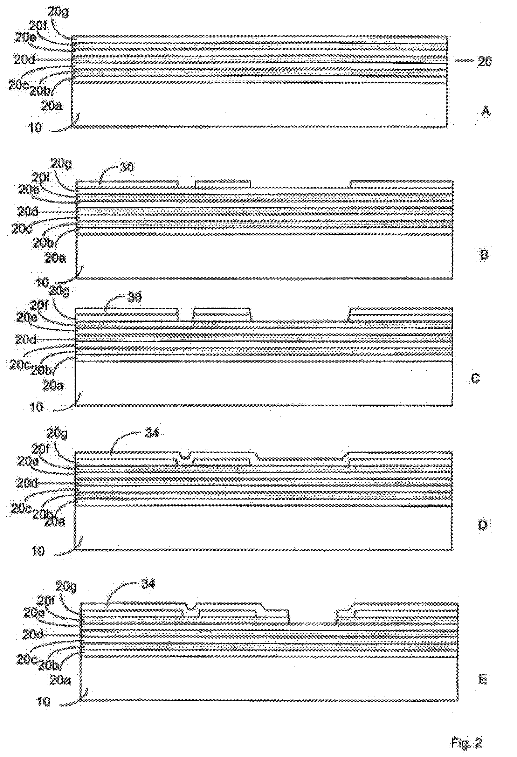

Figure 2 illustrates a preferred embodiment of the fabrication technique used to make an optical element OE according to the present invention.

In this embodiment a substrate 10 is provided. On a major surface of the substrate 10 a multi-layer stack 20 is deposited. The multi-layer stack 20 comprises alternating layers of two different materials which can be etched using plasma etching and which exhibit good selectivity properties. Thus, alternating layers 20a, 20c, 20e and 20g are comprised of a first material and layers 20b, 20d and 20f are comprised of a second type of material. Thus, each stack layer provides a natural etch stop allowing accurate step heights to be achieved during etching.

The multi-layer stack 20 may have its layers deposited by any means such as vacuum deposition for example. The thickness of each individual layer may be of the order of a few nanometers. The substrate 10 is preferably comprised of Si and the first and second materials may be alternating layers of Si and SiO₂.

As is shown in Figure 2B a resist layer 30 is deposited on the top surface of the stack 20 and is patterned according to known techniques. The resist 30 is then developed to leave behind some uncovered areas of the stack 20 which are exposed and others which are covered by resist 30.

Plasma etching of the top surface of the resist coated stack results in etching away of the top layer 20g of the stack 20 in areas which are exposed by the resist. In areas which are not exposed by the resist 30 the plasma etching has no affect on the top stack layer 20g. The type of plasma etching agent is chosen such that it only attacks material of the first type and not material of the second type. In this way, the layer 20F of the stack 20 is effective to prevent further etching once the top layer 20g has been removed. The plasma etching agent may be chlorine or florine based. Oxygen additions may be used.

Due to the isotropic nature of the plasma etch, the sides of the areas which have been removed are slightly angled rather than perpendicular to the remainder of the stack 20 with an incline to form an angle of more than 90° with the newly exposed layer 20F so that there is a smooth transition between levels. This is because plasma etching does not etch preferentially in any particular crystal direction so that areas which are more exposed are attached to a greater extent. This is advantageous as any film deposited over the surface (e.g. a reflective film) once the correct profile has been achieved adheres better to such a smooth transition between layers than it adheres to less smooth transitions.

If depths of greater than one layer are required the resist 30 can either be removed (e.g. by using a chemical resist stripper or by an oxygen plasma etch) and a completely fresh resist 34 applied to the top surface of the stack 20 as is illustrated in Figure 2D or the resist 30 may be left in place and a new resist 34 deposited over the old resist and the newly exposed layer 20F. In either case, the newly deposited resist 34 may then be patterned and developed to expose areas of newly exposed layer 20F which is made of a material different to the material of the top stack layer 20G. Plasma etching of this layer 20F follows using an etchant different (e.g. CF₄ based gas chemistry) to the etchant used to etch layer 20G. This plasma etching process results in a structure as illustrated in Figure 2E.

Repeating the process of depositing a resist developing it, plasma etching and removing the remains of the resist with alternating types of plasma etching agent can be used to reduce any relief in the stack required. The stack preferably comprises at least three layers but the number of layers will depend on the depth of relief required for the particular use. Typical etchants which may be used are described in Mendoza et al; "Dry Etch Technology For Large Area Flat Panels" in Semiconductor International, June 1999.

In the fabrication process, a film is deposited on the reliefed surface. The film may be a protective coating. Alternatively, the film may be a Bragg reflector which may compromise 40 or more periods of alternating layers of Molybdenum (Mo) and Silicon (Si) or Molybdenum and Beryllium (Be). Other materials and three or four layer periods may also be used. Further details of suitable reflectors formed of multilayer stacks may be found in EP-A-1 065 532, EP-A-1 065 568 and European Patent Application No. 02253475.4. A cap layer may be deposited on the upper surface of the Bragg reflector.

Whilst specific embodiments of the invention have been described above, it will be appreciated that the invention may be practiced otherwise than as described, the invention being defined by the appended claims.

## Claims

1. A method of fabricating an optical element comprising the steps of:
(a) providing a substrate (10);
(b) depositing a multi-layer stack (20) comprising alternating layers (20, 20a-g) of first and second materials on a surface of said substrate (10) wherein said two materials can provide relative etch selectivity;
(c) forming a resist layer (30) on top of said stack (20);
(d) patterning said resist layer (30) and developing said resist layer to uncover one or more regions of said stack (20);
(e) etching said one or more uncovered regions of said stack (20) to remove parts of one layer of said multi-layer stack (20) exposed by step (d) to form a relief profile; wherein a plasma etching agent is chosen such that it only attacks the first material and not the second material such that the layer of second material (20f) prevents further etching once the top layer of first material (20g) has been removed; and
(f) depositing a film on said relief profile,
wherein etching of the layer of first material follows using a plasma etching agent different to a plasma etching agent used to etch a layer of second material such that etching and removing the remains of the resist layer (30) is done with alternating types of plasma etching agent, and
wherein the etching is isotropic plasma etching such that sides of removed parts are slightly angled to form an angle of more than 90° with a newly exposed layer.

2. A method according to claim 1, wherein after step (e) remaining resist is removed said steps (c) to (e) are repeated a plurality of times before step (f).

3. A method of any one of the preceding claims, wherein said diffraction optics element is a fresnel type lens.

4. A method of any one of the preceding claims, wherein said film is a reflection film such as a Bragg reflector and/or a protective layer.

5. A lithographic projection apparatus comprising:
- a radiation system (LA, IL) for providing a projection beam (PB) of radiation;
- a support structure (MT) for supporting patterning means (MA), the patterning means (MA) serving to pattern the projection beam (PB) according to a desired pattern;
- a substrate table (WT) for holding a substrate (W);
- a projection system (PL) for projecting the patterned beam (PB) onto a target portion of the substrate,
**characterized by** further comprising an optical element fabricated by a method of any one of claims 1 to 4.

6. A device manufacturing method comprising the steps of:
- providing a substrate (W) that is at least partially covered by a layer of radiation-sensitive material;
- providing a projection beam (PB) of radiation using a radiation system (LA, IL);
- using patterning means (MA) to endow the projection beam (PB) with a pattern in its cross-section;
- projecting the patterned beam (PB) of radiation onto a target portion of the layer of radiation-sensitive material,
**characterized by** altering said projection beam using an optical element fabricated by a method of any one of claims 1 to 4.

## Patentansprüche

1. Ein Verfahren zum Fertigen eines optischen Elements, das die folgenden Schritte beinhaltet:
(a) Bereitstellen eines Substrats (10);
(b) Aufbringen eines mehrschichtigen Stapels (20), der alternierende Schichten (20, 20a-g) aus einem ersten und einem zweiten Material beinhaltet, auf eine Oberfläche des Substrats (10), wobei die zwei Materialien eine relative Ätzselektivität bereitstellen können;
(c) Bilden einer Photolackschicht (30) auf dem Stapel (20);
(d) Mustern der Photolackschicht (30) und Entwickeln der Photolackschicht zum Bloßlegen eines oder mehrerer Bereiche des Stapels (20);
(e) Ätzen des einen oder der mehreren bloßgelegten Bereiche des Stapels (20), um Teile einer durch Schritt (d) freigelegten Schicht des mehrschichtigen Stapels (20) zu entfernen, um ein Reliefprofil zu bilden; wobei ein Plasmaätzmittel derart gewählt wird, dass es nur das erste Material und nicht das zweite Material angreift, so dass die Schicht aus dem zweiten Material (20f) ein weiteres Ätzen verhindert, nachdem die Oberschicht aus dem ersten Material (20g) entfernt worden ist; und
(f) Aufbringen eines Films auf das Reliefprofil,
wobei das Ätzen der Schicht aus dem ersten Material der Verwendung eines Plasmaätzmittels folgt, das sich von einem zum Ätzen einer Schicht aus dem zweiten Material verwendeten Plasmaätzmittel unterscheidet, so dass das Ätzen und das Entfernen der Reste der Photolackschicht (30) mit alternierenden Arten von Plasmaätzmittel vorgenommen wird, und
wobei das Ätzen isotropes Plasmaätzen ist, so dass Seiten von entfernten Teilen geringfügig abgewinkelt sind, um mit einer neu freigelegten Schicht einen Winkel von mehr als 90° zu bilden.

2. Verfahren gemäß Anspruch 1, wobei, wenn nach Schritt (e) verbleibender Photolack entfernt ist, die Schritte (c) bis (e) eine Vielzahl von Malen vor Schritt (f) wiederholt werden.

3. Verfahren gemäß einem der vorhergehenden Ansprüche, wobei das Beugungsoptikelement eine fresnelartige Linse ist.

4. Verfahren gemäß einem der vorhergehenden Ansprüche, wobei der Film ein Reflexionsfilm wie etwa ein Bragg-Spiegel und/oder eine Schutzschicht ist.

5. Ein lithographisches Projektionsgerät, das Folgendes beinhaltet:
- ein Strahlungssystem (LA, IL) zum Bereitstellen eines Projektionsstrahls (PB) aus Strahlung;
- eine Stützstruktur (MT) zum Stützen eines Musteraufbringungsmittels (MA), wobei das Musteraufbringungsmittel (MA) dazu dient, den Projektionsstrahl (PB) gemäß einem gewünschten Muster zu mustern;
- einen Substrattisch (WT) zum Halten eines Substrats (W);
- ein Projektionssystem (PL) zum Projizieren des gemusterten Strahls (PB) auf einen Zielabschnitt des Substrats,
**dadurch gekennzeichnet, dass** es ferner ein durch ein Verfahren gemäß einem der Ansprüche 1 bis 4 gefertigtes optisches Element beinhaltet.

6. Ein Verfahren zum Herstellen einer Vorrichtung, das die folgenden Schritte beinhaltet:
- Bereitstellen eines Substrats (W), das mindestens teilweise von einer Schicht aus strahlungsempfindlichem Material bedeckt ist;
- Bereitstellen eines Projektionsstrahls (PB) aus Strahlung unter Verwendung eines Strahlungssystems (LA, IL);
- Verwenden eines Musteraufbringungsmittels (MA), um den Projektionsstrahl (PB) in seinem Querschnitt mit einem Muster zu versehen;
- Projizieren des gemusterten Strahls (PB) aus Strahlung auf einen Zielabschnitt der Schicht aus strahlungsempfindlichem Material,
**gekennzeichnet durch** das Modifizieren des Projektionsstrahls unter Verwendung eines durch ein Verfahren gemäß einem der Ansprüche 1 bis 4 gefertigten optischen Elements.

## Revendications

1. Un procédé de fabrication d'un élément optique comprenant les étapes consistant :
(a) à fournir un substrat (10) ;
(b) à déposer un empilement multicouche (20) comprenant des couches alternantes (20, 20a à g) de premier et deuxième matériaux sur une surface dudit substrat (10), où lesdits deux matériaux peuvent fournir une sélectivité de gravure relative ;
(c) à former une couche de réserve (30) sur ledit empilement (20) ;
(d) à conformer ladite couche de réserve (30) selon un motif et à développer ladite couche de réserve afin de découvrir une ou plusieurs régions dudit empilement (20) ;
(e) à graver lesdites une ou plusieurs régions découvertes dudit empilement (20) afin de retirer des parties d'une couche dudit empilement multicouche (20) exposées par l'étape (d) afin de former un profil en relief ; où il est choisi un agent de gravure par plasma de telle sorte qu'il n'attaque que le premier matériau et non le deuxième matériau de telle sorte que la couche de deuxième matériau (20f) empêche une gravure plus avant une fois que la couche supérieure de premier matériau (20g) a été retirée ; et
(f) à déposer un film sur ledit profil en relief,
où la gravure de la couche de premier matériau fait suite à l'utilisation d'un agent de gravure par plasma différent d'un agent de gravure par plasma utilisé afin de graver une couche de deuxième matériau de telle sorte que la gravure et le retrait des restes de la couche de réserve (30) soient effectués avec des types alternants d'agent de gravure par plasma, et
où la gravure est une gravure par plasma isotrope de telle sorte que des côtés de parties retirées soient légèrement en biais afin de former un angle de plus de 90° avec une couche nouvellement exposée.

2. Un procédé selon la revendication 1, où une fois la réserve restante de l'étape (e) retirée, lesdites étapes (c) à (e) sont répétées une pluralité de fois avant l'étape (f).

3. Un procédé de l'une quelconque des revendications précédentes, où ledit élément d'optique de diffraction est une lentille de type fresnel.

4. Un procédé de l'une quelconque des revendications précédentes, où ledit film est un film de réflexion tel qu'un réflecteur de Bragg et/ou une couche protectrice.

5. Un appareil de projection lithographique comprenant :
- un système de rayonnement (LA, IL) destiné à fournir un faisceau de projection (PB) de rayonnement ;
- une structure formant support (MT) destinée à supporter un moyen pour conformer selon un motif (MA), le moyen pour conformer selon un motif (MA) servant à conformer le faisceau de projection (PB) selon un motif souhaité ;
- une table porte-substrat (WT) destinée à porter un substrat (W) ;
- un système de projection (PL) destiné à projeter le faisceau à motif (PB) sur une portion cible du substrat,
**caractérisé par** le fait de comprendre en sus un élément optique fabriqué grâce à un procédé de l'une quelconque des revendications 1 à 4.

6. Un procédé de confection de dispositif comprenant les étapes consistant :
- à fournir un substrat (W) qui est au moins partiellement couvert par une couche de matériau sensible au rayonnement ;
- à fournir un faisceau de projection (PB) de rayonnement à l'aide d'un système de rayonnement (LA, IL) ;
- à utiliser un moyen pour conformer selon un motif (MA) afin de doter le faisceau de projection (PB) d'un motif dans sa coupe transversale ;
- à projeter le faisceau à motif (PB) de rayonnement sur une portion cible de la couche de matériau sensible au rayonnement,
**caractérisé par** le fait de modifier ledit faisceau de projection à l'aide d'un élément optique fabriqué grâce à un procédé de l'une quelconque des revendications 1 à 4.
